Europäisches Patentamt

European Patent Office

Office européen des brevets

(19)

(11) **EP 0 660 657 B1**

(12) **EUROPEAN PATENT SPECIFICATION**

(45) Date of publication and mention
of the grant of the patent:
**26.08.1998 Bulletin 1998/35**

(51) Int Cl.6: **H05K 13/08**

(21) Application number: **94120727.6**

(22) Date of filing: **27.12.1994**

(54) **Method and mounting device for mounting a component at a specific position**

Verfahren und Montagevorrichtung zum Montieren eines Bauelementes auf eine spezifische Position

Méthode et dispositif de montage pour le montage d'un composant sur une position spécifique

(84) Designated Contracting States:
**DE NL**

(30) Priority: **27.12.1993 JP 331222/93**

(43) Date of publication of application:
**28.06.1995 Bulletin 1995/26**

(73) Proprietor: **YAMAHA HATSUDOKI KABUSHIKI KAISHA**
**Iwata-shi Shizuoka-ken, 438 (JP)**

(72) Inventor: **Sakurai, Hiroshi**
**Iwata-shi, Shizuoka-ken (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**WO-A-92/14988**

- **PATENT ABSTRACTS OF JAPAN vol. 10 no. 32 (E-379) ,7 February 1986 & JP-A-60 189951 (FUJITSU KK) 27 September 1985,**

## Description

This invention relates to a method for mounting a component at a specific position as indicated in the preamble of claim 1 and moreover it relates to a mounting device for mounting a component at a specific position as indicated in the preamble of claim 8.

In a conventional mounter generally known (see for example WO-A-9 214 988), a head unit having a plural number of pickup nozzles for mounting chip components picks up small-sized chip components such as those for IC's from a component supply section provided with a plural number of rows of tape feeders for instance, moves the components to a positioned printed circuit board, and mount them at specified positions on the printed circuit board. In such a mounter, the head is moved in X axis and Y axis directions, and the pickup nozzles are moved in Z-axis direction and can also be rotated. For those movements and rotation, respective drive means are provided. Means for supplying vacuum to those drive means and nozzles are controlled by a control device. Thus, chip components are automatically mounted.

When such a mounter is used, there is a certain scatter in the positions of the picked up components and corrections are required accordingly. For that purpose, some known mounters are provided with a head unit having an optical detection means such as a laser unit to detect projected images of the chip components, or with a frame having a component recognition camera for taking images of the chip components, so that correction amounts for the mounting positions are obtained from the image information.

In the above mounter, the pickup point of the pickup nozzle when the chip component is picked up, or the position where the chip component is picked up by the nozzle, is usually set by a program. Therefore, if an initially set position of the tape feeder on the component supply section is displaced by a mechanical error, or if there is a head unit drive error at the time of picking up the chip component, the chip component is picked up always at a position displaced from the center of the chip component.

When correction of the mounting position is made according to the detected state of the picked up component, the greater the displacement of the pickup position, or the correction amount for the mounting position, the greater the possibility of the correction error. Furthermore, if the displacement of the pickup position is excessive, pickup may be imperfect. Therefore, it is preferable from the viewpoint of securing mounting accuracy to cause the pickup nozzle to pick up the center of the component with less pickup displacement.

It is therefore an objective of the present invention to provide an improved method and mounting device for mounting a component at a specific position so that the component is picked up with higher accuracy at its center in order to improve the mounting accuracy.

According to the present invention, the aforementioned objective concerning the method is performed by the step of changing the predetermined pick up position of the pick-up nozzle for the component to be picked up next in response to the deviation detected.

According to the present invention, the aforementioned objective concerning the mounting device is performed in that a pick up point changing means is provided for changing the predetermined pick up point of the pick-up nozzle in response to the correction values.

The step of changing the pick-up position of the pick-up nozzle allows to pick up the chip component at its center with a higher accuracy so that the mounting accuracy can be improved.

According to a preferred embodiment of the invention, an average correction value is calculated from a predetermined number of correction values and the predetermined pick up position of the pick-up nozzle is changed in response to said average correction value. That means the deviation of the component being picked up from a predetermined component position relative to the pick-up nozzle is repeatedly detected for several times and used for changing the predetermined pick up position of the pick-up nozzle.

Further preferred embodiments of the present invention are laid down in the further dependent claims.

Hereinafter the present invention is illustrated and explained in greater detail by means of a preferred embodiment and accompanying drawings, wherein,

Fig. 1 is an overall plan view of a mounting device including a movable mounting head and a component supply unit according to an embodiment of the present invention;

Fig. 2 is a front view of the mounting device with the mounting head comprising three pick-up nozzles according to the embodiment of the invention of fig. 1;

Fig. 3 shows the mounting head having three pick-up nozzles in an enlarged view of the mounting head according to the embodiment of fig. 1;

Fig. 4 is a block diagram showing the control system of the mounting device according to the embodiment of fig. 1;

Fig. 5 is a flow chart showing the pick up operation of the mounting device having three pick-up nozzles according to the embodiment of fig. 1;

Fig. 6 is a flow chart showing the pick-up point changing control of the mounting device according to the embodiment of fig. 1.

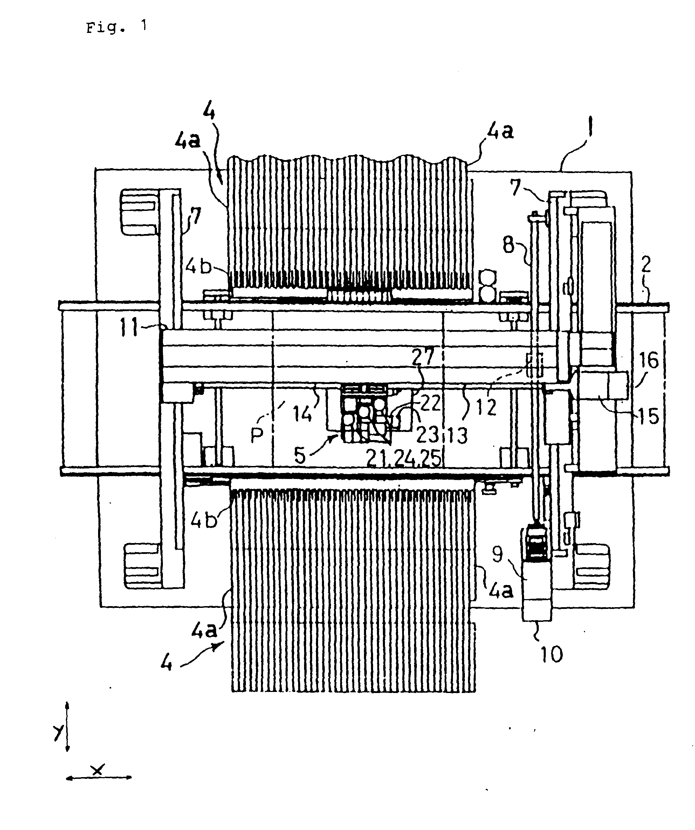

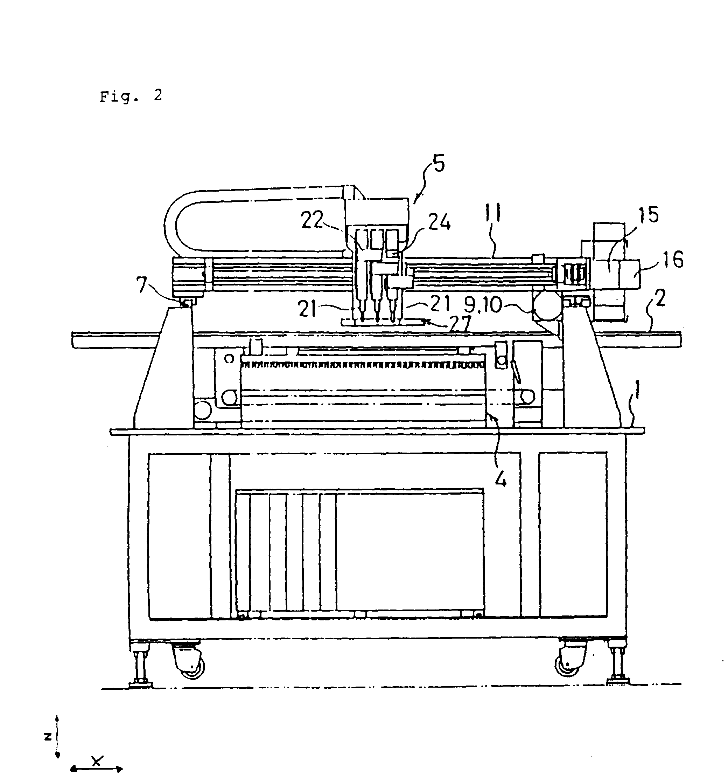

As shown in fig. 1 and 2, a conveyor 2 for conveying printed circuit boards is located on a frame 1. The printed circuit boards P are conveyed along the conveyor 2 and positioned and held at a specified mounting work position.

Component supply sections 4 are located on both sides of the conveyor 2. The component supply section 4 comprises a plural number of rows of tape feeders 4a. Each tape feeder comprises a tape to be drawn out from a reel and holding small-sized chip components such as those for IC's, transistors, and capacitors at specified intervals. A ratchet type feeder mechanism is provided at the tape feed out end 4b so that the tape is periodically fed out as the chip components are picked up by a head unit 5 which will be described later.

The head unit 5 for mounting components is located above the frame 1 to be capable of moving in X axis (conveyor 2 movement) and Y axis (normal to the X axis in horizontal plane) directions.

A pair of fixed rails 7 extending in the Y direction and a ball screw axis 8 rotatably driven by a Y axis servomotor 9 are located on the frame 1. A head unit support member 11 is installed on the fixed rails 7. A nut 12 provided on the support member 11 is in screw engagement with the ball screw axis 8. The support member 11 is also provided with a guide member 13 extending in the X axis direction, and a ball screw axis 14 rotatably driven by an X axis servomotor 15. The head unit 5 is movably supported by the guide member 13. A nut (not shown) mounted in the head unit 5 is in screw engagement with the ball screw axis 14. When the ball screw axis 8 is rotated by the operation of the Y axis servomotor 9, the support member 11 moves in the Y axis direction. When the ball screw axis 14 is rotated by the operation of the X axis servomotor 15, the head unit 5 moves in the X axis direction along the support member 11.

The Y axis servomotor 9 and the X axis servomotor 15 are respectively provided with position detection means 10 and 16 comprising encoders.

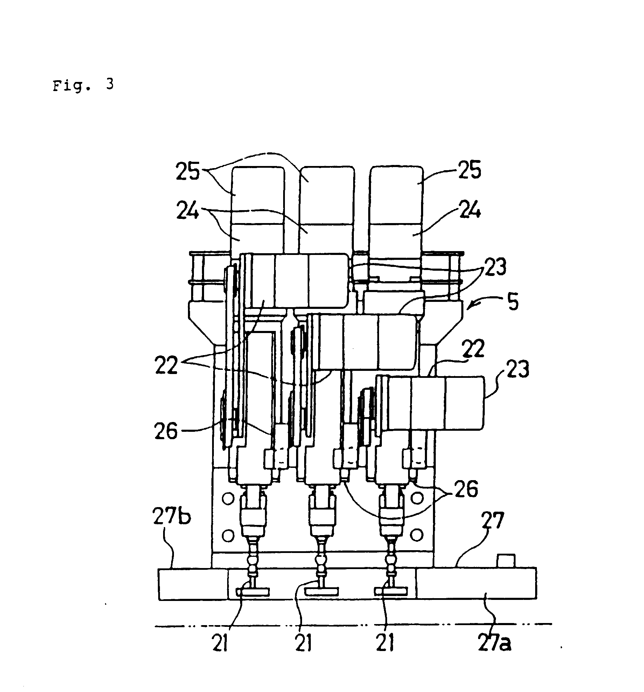

As shown in FIG. 3 in detail, the head unit 5 is provided with pickup nozzles 21 for picking up chip components. In the embodiment shown, the number of the nozzles 21 is three. Each pickup nozzle 21 is capable of moving in the Z axis (up and down) direction and rotating about Z axis (nozzle center axis) and respectively driven by a Z axis servomotor 22 and an R axis servomotor 24. The servomotors 22 and 24 are respectively provided with detection means 23 and 25 comprising encoders.

In the head unit 5, each pickup nozzle 21 is provided with interference position detection means 26 for detecting the position of the pickup nozzle 21 interference with the component supply section 4.

Vacuum means (not shown) is connected to the pickup nozzles 21 by way of a valve or the like to apply vacuum to the pickup nozzles 21 when required to pick up chip components.

A laser unit 27 is attached to the lower end of the head unit 5. The laser unit 27 detects projected width of the chip component when parallel light beams or laser beams are cast on the chip component in the state of being picked up. Two components of the laser unit 27, a laser generating section (parallel beam casting section) 27a and a detector (photocell section) 27b comprising a CCD, facing each other, are located on both sides of the pickup nozzle 21.

The pickup nozzles 21 and the laser unit 27 of the head unit 5 are located to avoid overlapping of the pickup nozzles 21 each other in the direction of casting laser beams. In other words, in the embodiment (FIG. 1, though not much in detail), while the laser unit 27 is oriented so that the laser beams are cast in the X axis direction, the pickup nozzles 21 are obliquely staggered with respect to the X axis, and that the images of the nozzles 21 are projected on different areas of the detector 27b of the laser unit 27. While the chip components are usually picked up as shown in FIG. 1, with one component for each pickup nozzle 21, a relatively large chip component will be picked up by the pickup nozzle 21 in the center only, or by the pickup nozzles on both sides only. Thus, the pickup nozzles 21 are suitably selected according to the sizes of the chip components to be picked up.

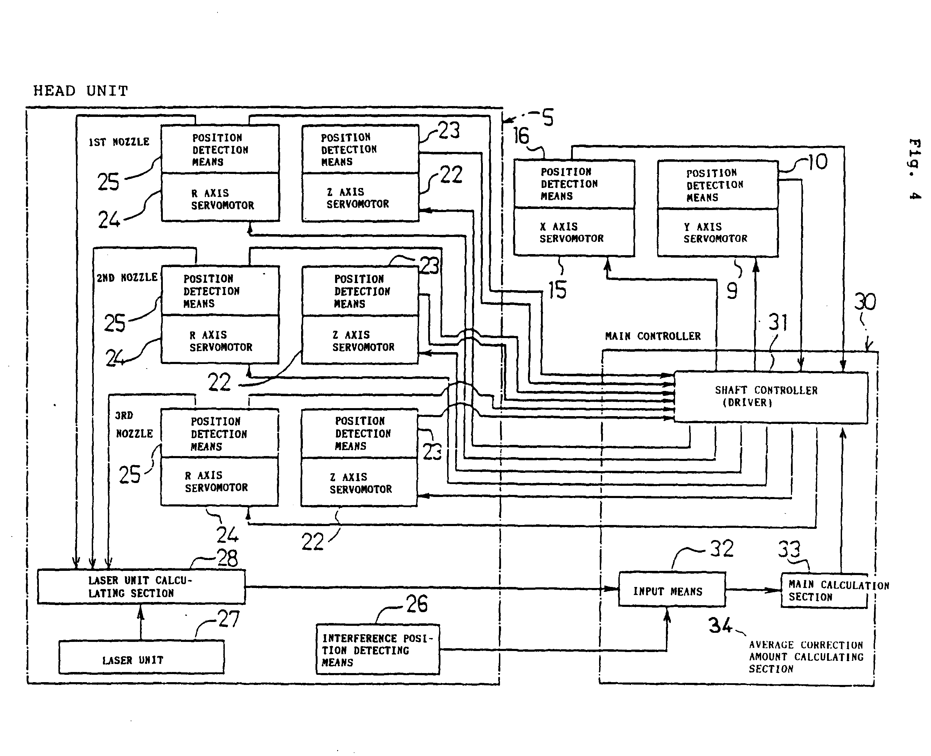

FIG. 4 shows an embodiment of a control system for the mounter described above.

In the drawing, electric connections are made from a shaft controller (driver) 31 of a main controller 30 to the servomotors 9, 15, 22 and 24, and the position detection means 10, 16, 23 and 25 respectively provided on those servomotors. The laser unit 27 is electrically connected to a main calculating section 33 by way of an input output means 32. The main calculating section 33 is further connected to an average correction amount calculating section 34. Interference position detection means 26 is connected to the input output means 32.

The main calculating section 33 performs automatic pickup and mounting of the chip components according to a program preset according to the circuit board on which the chip components are to be mounted. At the time of component recognition, the main calculating section 33 controls the operations of the servomotors 9, 15, 22 and 24 by way of the shaft controller 31 to detect the projected widths of the picked up chip components, while holding them at a specified height and rotating them, by means of the laser unit 27.

The main calculating section 33 also performs the process of determining the mounting position correction amounts for the chip components to be mounted according to signals issued from the laser unit calculating section 28 through the input output means 32, namely according to signals representing the projected chip component widths detected by the laser unit 27. The determined data representing the correction amount is issued to the shaft controller 31 and the average correction amount calculating means 34. In other words, the main calculating section 33 in the mounter serves as correction amount calculating means.

The average correction amount calculating means 34 stores the correction amounts issued from the main calculating section 33 in succession in a memory section (not shown). When the number of stored data reaches a preset value, the average correction amount calculating means 34 reads the stored data and calculates the average of those data, namely the average correction amount. More precisely, the average correction amount calculating means 34 is provided with three memory sections respectively corresponding to the first through third pickup nozzles 21 for storing the correction amount data issued from the main calculating section 33. To calculate the correction amount, first an average correction amount is calculated for each of the first through third pickup nozzles 21, and then an average correction amount is calculated from the individual average correction amounts. The average correction amounts calculated as described above by the average correction amount calculating means 34 is issued to the main calculating section 33. The main calculating section 33 renews program data for the pickup point for the pickup nozzle 21. In other words, the pickup point changing means comprises the main calculating section 33 and the average correction amount calculating means 34.

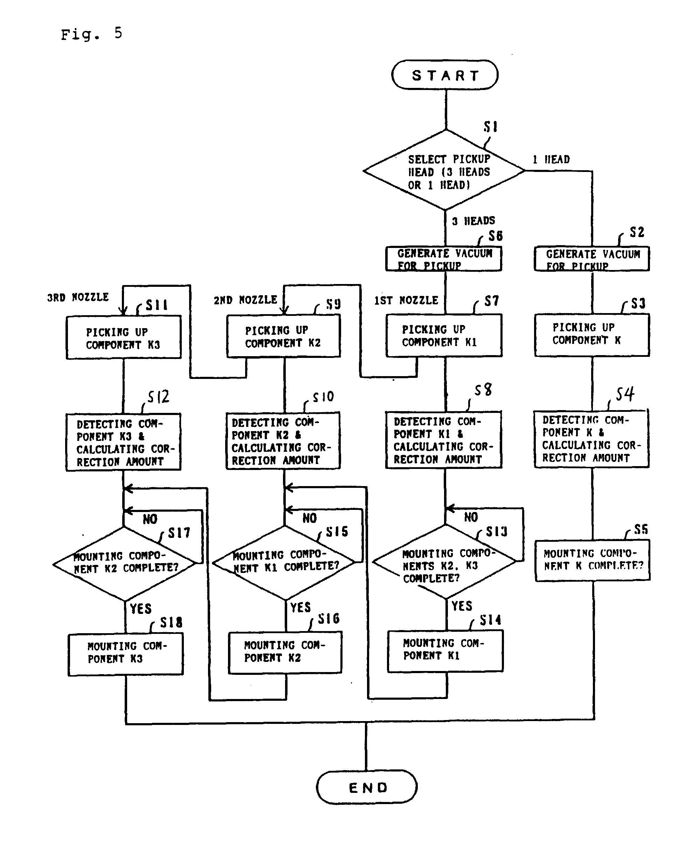

An example of control by the main controller 30 will be described below in reference to the flow chart shown in FIG. 5.

FIG. 5 shows a main routine of entire process of the chip component pickup and mounting operations. While the mounter described above is capable of performing the mounting operation by selectively using the three pickup nozzles 21 according to the sizes of the chip components, the following description is made about selective use of either one or three pickup nozzles 21 for the mounting operation.

First in step S1, discrimination is made according to the size of the chip component to be mounted if the mounting operation should be performed by one pickup nozzle 21 or by three pickup nozzles 21.

When the mounting operation by one pickup nozzle 21 is selected in the step S1, the process proceeds to step S2. In the step S2, vacuum is applied from a vacuum generating means (not shown) to one of the three pickup nozzles 21, and the head unit 5 is moved in the X axis and Y axis directions. When the head unit 5 reaches a position corresponding to the component supply section 4, the pickup nozzle 21 is lowered and an intended chip component K is picked up (step S3).

When the pickup of the chip component K is complete, the pickup nozzle 21 is raised, the head unit 5 is moved to the printed circuit board side to mount the chip component K. During the movement of the head unit 5, the chip component K is recognized (the chip component K is detected and the correction value for the component mounting position is calculated according to the detected data) by the laser unit 27 (step S4).

When the head unit 5 reaches a position corrected by the correction value, the pickup nozzle 21 is lowered with simultaneous stop of application of vacuum to the pickup nozzle 21, and the mounting of the chip component K to the printed circuit board is complete (step S5).

When mounting operation by three pickup nozzles 21 is selected in the step S1 (in the following description of the process flow, discrimination will be made to refer them respectively as the first, second, and third pickup nozzles), the process proceeds to step S7. Here, the operations of the first through third pickup nozzles are fundamentally identical each other, and operation periods of respective pickup nozzles overlap each other.

In other words, simultaneously with the application of vacuum for chip component pickup to the first through third pickup nozzles in step S6, the head unit 5 is moved to the component supply section 4, the first nozzle 21 is lowered, and an intended chip component K1 is picked up (step S7).

When pickup of the chip component K1 by the first pickup nozzle is complete, the head unit 5 is moved for picking up a chip component by the second pickup nozzle. When the head unit 5 reaches a position above the component supply section 4, the second pickup nozzle lowers and picks up the intended chip component K2. At the same time, component recognition for the chip component K1 picked up by the first pickup nozzle is performed by the laser unit 27 (steps S8 and S9).

When pickup of the chip component K2 by the second pickup nozzle is complete, the head unit 5 is moved for picking up a chip component by the third pickup nozzle. When the head unit 5 reaches a position above the component supply section 4, the second pickup nozzle lowers and picks up the intended chip component K3. At the same time, component recognition for the chip component K2 picked up by the second pickup nozzle is performed by the laser unit 27 (steps S10 and S11).

When pickup of the chip component K3 by the third pickup nozzle is complete, component recognition for the chip component K3 picked up by the third pickup nozzle is performed by the laser unit 27 (steps S12).

On the other hand, after the completion of the component recognition of the chip component K1 in the step S8, discrimination is made in step S13 if the pickups of the chip components K2 and K3 are complete. If the pickup of the chip component K3 is complete (YES in the step S3), the process proceeds to step S14 to mount the chip component K1. Namely, the head unit 5 is moved to the printed circuit board side, or to the position corrected with the correction amount for mounting the chip component K1. When the head unit 5 reaches the intended position, the first pickup nozzle lowers while vacuum is gradually weakened so that the chip component K1 is mounted on the printed circuit board. Then the process proceeds to step S15.

In the step S15, it is discriminated whether mounting the chip component K1 by the first nozzle is complete. If complete (YES in the step S15), the process proceeds to step S16 to mount the chip component K2, and proceeds to step S17.

In the step S17, it is discriminated whether mounting the chip component K2 by the second nozzle is complete. If complete (YES in the step S17), the process proceeds to step S18 to mount the chip component K3.

When mounting the chip component K3 by the third nozzle is complete, the process of the flow chart is over.

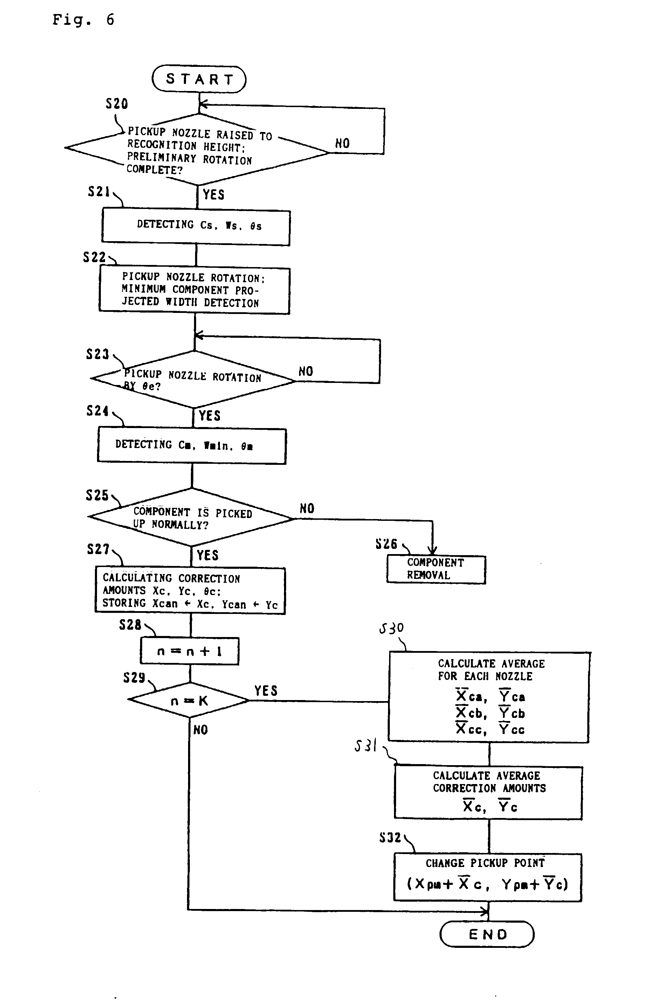

Next, process of changing the pickup point while picking up and mounting the component are being done will be described in reference to the flow chart shown in FIG. 6. This process is done at the time of the component recognition (steps S4, S8, S10, and S12) shown in the flow chart in FIG. 5. In the following description, it is assumed that picking up the chip components is done with the three pickup nozzles 21 (the first through third nozzles 21a through 21c in the description of the following process flow) and that the shape of the chip component is rectangular.

When the chip component is picked up by the first nozzle 21a from the component supply section 4, the chip component in the state of being picked up by the pickup nozzle 21 is raised to a specified height for recognition, and rotated by a specified angle with respect to the direction of the laser beam (X axis direction) of the laser unit 27 (preliminary rotary action). This places the chip component in an initial position with its longer side tilted relative to the direction of the laser beam of the laser unit 27.

In the step S20 of the flow chart, it is discriminated whether the first nozzle 21a is raised to the specified recognition height and the preliminary rotary action is complete. If complete (YES in the step S20), the process proceeds to step S21.

In the step S21, the chip component placed in the initial position as described above is detected for its projected width $Ws$, central position $Cs$, and rotary angle $\theta s$ at that time point.

When the above detection is complete, measurement of the projected width of the chip component is repeated while the chip component is rotated from the initial position by a specified angle of $\theta e$ to find a position where the projected width is minimum. At that position, the minimum projected width $Wmin$, the central position $Cm$, and the rotary angle $\theta m$ are detected (steps S22 through S24).

In step S25, it is discriminated according to these data ($Wmin$, $Cm$, and $\theta m$) whether the chip component is picked up correctly. If not (NO in the step S25), the process proceeds to step S26, and the chip component is removed. If yes (YES in the step S25), the process proceeds to step S27 and mounting position correction amounts $Xc$, $Yc$, and $\theta c$ are calculated for the directions X, Y, and $\theta$. In other words, in the step S27, the length of the shorter side, displacement of the component central position in the shorter side direction of the chip component, and rotary angle displacement are obtained from the minimum projected width $Wmin$, central position $Cm$, and rotary angle $\theta$. From these and other data, the length of the longer side, and the displacement of the component central position in the longer side direction are obtained. From these results, the mounting position correction amounts $Xc$, $Yc$, and $\theta c$ are calculated. While the head unit 5 is being moved to the mounting position corrected with the calculated mounting position correction amounts and the chip component is being mounted, the correction amount $Xc$ in the X axis direction and the correction amount $Yc$ in the Y axis direction out of the mounting position correction amounts are stored in an average correction amount calculating section 34 of the main controller 30. In other words, the correction amounts ($Xca1$, $Yca1$) for the chip component picked up by the first nozzle 21a are stored in the average correction amount calculating section 34. Although a description is omitted, the correction amounts ($Xcb1$, $Ycb1$) for the chip component picked up by the second nozzle 21b and the correction amounts ($Xcc1$, $Ycc1$) for the chip component picked up by the third nozzle 21c are respectively calculated in a similar manner and stored in the average correction amount calculating section 34.

While the the head unit 5 goes and returns between the component supply side 4 and the printed circuit board for one cycle to mount the three chip components, a counter in the average correction amount calculating section 34 is counted up (step S28), and the process proceeds to step S29.

In the step S29, whether the counted value of the counter reached a specified value k is discriminated, and if not, the process of this flow chart is finished.

If the counted value has reached the preset value k, the process proceeds to step S30, and an average of the mounting position correction amount data stored as described above in the average correction amount calculating section 34 is calculated. Here, first in the average correction amount calculating section 34, as shown with the equations (1) through (6) described below, averages of X axis direction correction amounts and Y axis direction correction amounts are respectively calculated from the correction amount data of the first through third nozzles 21a through 21c. As further shown with the equations (7) and (8), an average for each direction, namely an average correction amount, is calculated from the average correction amounts for each of the X axis and Y axis directions (step S31).

$$\left( \begin{array}{l} \overline{X}_{ca} = \dfrac{X_{ca1} + X_{ca2} + \cdots + X_{cak}}{k} \quad \cdots\cdots\cdots\cdots\cdots \quad (1) \\[2em] \overline{Y}_{ca} = \dfrac{Y_{ca1} + Y_{ca2} + \cdots + Y_{cak}}{k} \quad \cdots\cdots\cdots\cdots\cdots \quad (2) \end{array} \right.$$

$$\left( \begin{array}{l} \overline{X}_{cb} = \dfrac{X_{cb1} + X_{cb2} + \cdots + X_{cbk}}{k} \quad \cdots\cdots\cdots\cdots\cdots \quad (3) \\[2em] \overline{Y}_{cb} = \dfrac{Y_{cb1} + Y_{cb2} + \cdots + Y_{cbk}}{k} \quad \cdots\cdots\cdots\cdots\cdots \quad (4) \end{array} \right.$$

$$\left( \begin{array}{l} \overline{X}_{cc} = \dfrac{X_{cc1} + X_{cc2} + \cdots + X_{cck}}{k} \quad \cdots\cdots\cdots\cdots\cdots \quad (5) \\[2em] \overline{Y}_{cc} = \dfrac{Y_{cc1} + Y_{cc2} + \cdots + Y_{cck}}{k} \quad \cdots\cdots\cdots\cdots\cdots \quad (6) \end{array} \right.$$

$$\overline{X}_c = \frac{\overline{X}_{ca} + \overline{X}_{cb} + \overline{X}_{cc}}{3} \tag{7}$$

$$\overline{Y}_c = \frac{\overline{Y}_{ca} + \overline{Y}_{cb} + \overline{Y}_{cc}}{3} \tag{8}$$

When the average correction amounts are obtained as described above, as shown with the equations (9) and (10) below, the program data of the current pickup point (Xpm, Ypm) for the tape feeders 4a by the pickup nozzle 21 are renewed to those representing a new pickup point (X, Y) corrected with the average correction amounts described above.

$$X = Xpm + \overline{X}_c \tag{9}$$

$$Y = Ypm + \overline{Y}_c \tag{10}$$

When the new pickup point is set up as described above, the process of the flow chart is over, and then the chip component is picked up from the component supply section 4 by the mounter.

The mounter described above, in which the component mounting position correction amounts obtained with the main calculating section 33 are sampled, averages are obtained from those sampled amounts and used to correct the pickup point by renewed setting of the pickup point, is capable of picking up the central position of the chip component more accurately in comparison to conventional mounters. This makes it possible to improve mounting accuracy.

With the conventional mounter in which the pickup point is preset, if the pickup point of the chip component is displaced as a result of a mechanical error in the initial setting position of the tape feeders relative to the component supply section, or as a result of a drive error of the head unit, the chip components fed out from the tape feeders are picked up always at a point displaced from the chip component central position. With the mounter of the above embodiment, however, the component mounting position correction amounts obtained by the main calculating section 33 are sampled and averaged, the average correction amount is assumed to be the displacement of the pickup point of the chip component fed out from the tape feeder 4a, and used to correct or renew the pickup point. As a result, even if the pickup point of the chip component is displaced from the chip component central position as a result of a mechanical error in the initial setting position of the tape feeders 4a relative to the component supply section 4, or as a result of a drive error of the head unit 5, the pickup point is made to agree with or come nearer to the chip component central position by renewing the pickup point by additional use of the average correction amount.

In the mounter described above in which the chip component is picked up by the pickup nozzle 21 at a position as near as possible to the center of the chip component, the mounting position correction amount is a small value and therefore makes the error in the mounting position correction a small value, improves mounting accuracy, and reduces the possibility of incomplete pickup due to excessive displacement in the pickup position.

The embodiment described above shows only one of embodiments of this invention and the specific structure is not limited to the above embodiment. For instance, while the number of the nozzles 21 is three in the embodiment, the number may be greater or smaller than three. For other structural features other than the number of the nozzles, they may be changed.

When correcting the pickup point, the calculation for obtaining the average correction amount should not necessarily be made for all the pickup nozzles 21 but as a matter of course the correction of the pickup point may be made using the average correction amount for one pickup nozzle only. However, more accurate pickup point correction can be made if, as described above, the mounting position correction amounts are sampled and averaged for each of the three pickup nozzles 21, and the averages for respective pickup nozzles 21 are further averaged.

According to the described embodiment, when the pick-up nozzle moves to a specified pickup point and picks up a chip component, the chip component is recognized by a component recognizing device. Then a component mounting position correction amount is determined from the recognized result, and the chip component is mounted according to a data corrected with the correction amount. While the operations described above are repeated for several times, the correction amounts determined by the average correction amount calculating means are sampled and an average is determined from the sampled data. Then the pickup point of the pickup nozzle is changed to a position according to the data corrected with the average correction amount. Thus, the mounting accuracy is improved.

## Claims

1. Method for mounting a component at a specific position, specifically a chip component on a substrate such as a printed circuit board (P), comprising the steps of picking up the component through a pick-up nozzle (21) from a component supply unit (4) at a predetermined pick-up position of the pick-up nozzle, transferring the component and placing the same in a detection area of an optical detecting means (27) for detecting a deviation of the component being picked up from a predetermined component position relative to the pick-up nozzle (21), and mounting the component at the desired position, **characterised by** the step of changing the predetermined pick up position of the pick-up nozzle (21) for the component to be picked up next in response to said deviation detected.

2. Method according to claim 1, **characterised in that** a correction value ($X_{cak}$, $Y_{cak}$, $X_{cbk}$, $Y_{cbk}$, $X_{cck}$, $Y_{cck}$) for correcting a predetermined mounting position of the pick-up nozzle (21) for mounting the component at said specific position is calculated in response to said deviation.

3. Method according to claim 2, **characterised in that** an average correction value ($\bar{X}_c$, $\bar{Y}_c$) is calculated from a predetermined number of correction values ($X_{cak}$, $Y_{cak}$, $X_{cbk}$, $Y_{cbk}$, $X_{cck}$, $Y_{cck}$) and the predetermined pick up position of the pick-up nozzle (21) is changed in response to said average correction value ($\bar{X}_c$, $\bar{X}_c$).

4. Method according to at least one of claims 1 to 3, **characterised in that** a plurality of components ($K_1$, ...$K_n$) is picked up through a plurality of pick-up nozzles (21) simultaneously or successively, while further steps for detecting said deviation and obtaining correction values are performed, at least partially, in a time sharing procedure.

5. Method according to claim 4, **characterised in that** an average correction value ($\bar{X}_{ca}$, $\bar{Y}_{ca}$, $\bar{X}_{cb}$, $\bar{Y}_{cb}$, $\bar{X}_{cc}$, $\bar{Y}_{cc}$) is calculated for each pick-up nozzle (21) separately from a predetermined number of correction values ($X_{cak}$, $Y_{cak}$, $X_{cbk}$, $Y_{cbk}$, $X_{cck}$, $Y_{cck}$) for each pick-up nozzle (21), and the average correction value ($\bar{X}_c$, $\bar{Y}_c$) for changing the pick up points (X, Y) of the pick-up nozzles (21) is calculated from the individual average correction values ($\bar{X}_{ca}$, $\bar{Y}_{ca}$, $\bar{X}_{cb}$, $\bar{Y}_{cb}$, $\bar{X}_{cc}$, $\bar{Y}_{cc}$) for each pick-up nozzle (21).

6. Method according to at least one of claims 2, 3 and 5, **characterised in that** the component placed in the detection area is subject to parallel light beams and rotated by said pick-up nozzle (21) around an axis substantially perpendicular to the light beams, and, during rotation, the projected width ($W_s$) is repeatedly detected so as to determine the minimum projected width ($W_{min}$) of the component and the associated rotation angle ($\phi$) and to obtain said correction value ($X_{cak}$, $Y_{cak}$, $X_{cbk}$, $Y_{cbk}$, $X_{cck}$, $Y_{cck}$) therefrom.

7. Method according to claim 6, **characterised in that** the component is subject to laser beams emitted in parallel in a plane (X-Y) substantially perpendicular to the axis around which the component is rotated.

8. Mounting device for mounting a component at a specific position, especially a chip component on a substrate such as a printed circuit board (P), comprising a movable mounting head unit (5) supporting at least one pick-up nozzle (21) for picking up at least one component from a component supply unit (4) at a predetermined pick-up point (X, Y) of the pick-up nozzle, a position detecting means (27) for detecting a deviation of the picked up component from a predetermined position relative to the pick-up nozzle (21), and correction value calculating means (33) for calculating correction values ($X_{cak}$, $Y_{cak}$, $X_{cbk}$, $Y_{cbk}$, $X_{cck}$, $Y_{cck}$) for correcting a predetermined mounting position of the pick-up nozzle for mounting the component at said specific position (21) in response to said deviation, **characterised in that** a pick up point changing means (33, 34) is provided for changing the predetermined pick up point (X, Y) of the pick-up nozzle (21) in response to said correction values ($X_{cak}$, $Y_{cak}$, $X_{cbk}$, $Y_{cbk}$, $X_{cck}$, $Y_{cck}$).

9. Mounting device according to claim 8, **characterised in that** said pick up point changing means comprises an average calculating means (34) for calculating an average correction value ($\bar{X}_c$, $\bar{Y}_c$) from a predetermined number of correction values ($X_{cak}$, $Y_{cak}$, $X_{cbk}$, $Y_{cbk}$, $X_{cck}$, $Y_{cck}$) obtained by the correction value calculating means (33), the pick up point (X, Y) of the pick-up nozzle (21) being changed in response to said average correction value ($\bar{X}_c$, $\bar{X}_c$).

10. Mounting device according to claim 8 or 9, **characterised in that** the mounting head unit (5) comprises a plurality of pick-up nozzles (21) for picking up a plurality of components.

11. Mounting device according to claim 10, **characterised in that** the average calculating means (34) is adapted to calculate an average correction value ($\bar{X}_{ca}$, $\bar{Y}_{ca}$, $\bar{X}_{cb}$, $\bar{Y}_{cb}$, $\bar{X}_{cc}$, $\bar{Y}_{cc}$) for each pick-up nozzle (21) from a predetermined number of correction values ($X_{cak}$, $Y_{cak}$, $X_{cbk}$, $Y_{cbk}$, $X_{cck}$, $Y_{cck}$) for each pick-up nozzle (21) and further to calculate an average correction value ($\bar{X}_c$, $\bar{Y}_c$) for changing the pick up point (X, Y) from the individual average correction values ($\bar{X}_{ca}$, $\bar{Y}_{ca}$, $\bar{X}_{cb}$, $\bar{Y}_{cb}$, $\bar{X}_{cc}$, $\bar{Y}_{cc}$) of each pick-up nozzle (21).

12. Mounting device according to claim 11, **characterised in that** the average calculating means (34) comprises three memory means for storing the individual average correction values ($\bar{X}_{ca}$, $\bar{Y}_{ca}$, $\bar{X}_{cb}$, $\bar{Y}_{cb}$, $\bar{X}_{cc}$, $\bar{Y}_{cc}$) associated with each pick-up nozzle (21).

13. Mounting device according to at least one of claims 8 to 12, **characterised in that** the position detecting means comprises a laser unit (27) for detecting a projected width ($W_s$) of the component being picked up and rotated by means of parallel light beams emitted from a laser generating section (27a) disposed at one side of the mounting head unit (5) and received from a detecting section (27b) disposed at the opposite side of the mounting unit (5) with the pick-up nozzle (21) being disposed between said generating section (27a) and said detecting section (27b).

14. Mounting device according to claims 11 and 13, **characterised in that** each pick-up nozzle (21) is supported rotatably about its vertical axis (R-axis) and displaceable vertically along an axis (Z-axis) independently from each other and movable in a plane (X-axis, Y-axis) perpendicular to said vertical axis (Z-axis) together with said mounting head unit (5), said pick-up nozzles (21) being arranged along a line oblique with respect to the direction of the parallel light beams of the position detecting means (27) so that components attracted to the pick-up nozzles (21) do not overlap in the direction of said parallel light beams.

15. Mounting device according to at least one of claims 8 to 14, **characterised in that** servomotors (22, 24) are connected to the each pick-up nozzle (21) for rotating and displacing the same, respectively, relative to the mounting head unit (5), servomotors (9, 15) are provided for moving the mounting head unit (5) in the X-axis direction and the Y-axis direction, position detecting means (23, 25, 10, 16) being associated with each of said servomotors (22, 24, 9, 15), and that said servomotors (22, 24, 9, 15) and said detecting means (23, 25, 10, 16) are electrically connected to a main controller (30).

16. Mounting device according to claims 13 and 15, **characterised in that** said main controller (30) comprises the pick up point changing means including the average calculating means (34) and is electrically connected to the laser unit (27) via a laser unit calculating section (38) and an input means (32).

17. Mounting device according to at least one of claims 8 to 15, **characterised in that** the each pick-up nozzle (21) is provided with an interference position detecting means (26) for detecting a position of interference of the component supply unit (4) and the pick-up nozzle (21).

**Patentansprüche**

1. Verfahren zum Montieren eines Bauelementes an einer spezifischen Position, insbesondere eines Chipbauteils auf einem Substrat, wie z.B. einer gedruckten Leiterplatte (P), mit den Schritten:
Aufnehmen des Bauelementes mittels einer Aufnahmedüse (21) von einer Zuführeinheit (4) für Bauelemente mit einer vorbestimmten Aufnahmeposition der Aufnahmedüse, Überführen des Bauelementes und Plazieren desselben in einem Erfassungsbereich einer optischen Erfassungseinrichtung (27) zur Erfassung einer Abweichung des Bauelementes, das relativ zu der Aufnahmedüse (21) in einer vorbestimmten Bauelement-Position aufgenommen worden ist, sowie Montieren des Bauelementes an der gewünschten Position, **gekennzeichnet durch** die Schritte des Änderns der vorbestimmten Aufnahmeposition der Aufnahmedüse (21) für das nächste aufzunehmende Bauelement in Abhängigkeit von der erfaßten Abweichung.

2. Verfahren nach Anspruch 1, **dadurch gekennzeichnet,** daß ein Korrekturwert ($X_{cak}$, $Y_{cak}$, $X_{cbk}$, $Y_{cbk}$, $X_{cck}$, $Y_{cck}$) für die Korrektur einer vorbestimmten Montageposition der Aufnahmedüse (21) für die Montage des Bauelementes an dieser spezifischen Position in Abhängigkeit von dieser Abweichung berechnet wird.

3. Verfahren nach Anspruch 2, **dadurch gekennzeichnet,** daß ein Korrekturmittelwert ($\overline{X}_c$, $\overline{Y}_c$) von einer vorbestimmten Anzahl von Korrekturwerten ($X_{cak}$, $Y_{cak}$, $X_{cbk}$, $Y_{cbk}$, $X_{cck}$, $Y_{cck}$) berechnet und die vorbestimmte Aufnahmeposition der Aufnahmedüse (21) in Abhängigkeit von diesem Korrekturmittelwert ($\overline{X}_c$, $\overline{Y}_c$) geändert wird.

4. Verfahren nach zumindest einem der vorstehenden Ansprüche 1 bis 3, **dadurch gekennzeichnet,** daß eine Vielzahl von Bauelementen ($K_1$, ...$K_n$) mittels einer Vielzahl von Aufnahmedüsen (21) simultan oder sukzessive aufgenommen wird, während weitere Schritte für die Erfassung dieser Abweichung und für das Erhalten der Korrekturwerte zumindst teilweise in einem Time-Sharing-Verfahren durchgeführt werden.

5. Verfahren nach Anspruch 4, **dadurch gekennzeichnet,** daß ein Korrekturmittelwert ($\overline{X}_{ca}$, $\overline{Y}_{ca}$, $\overline{X}_{cb}$, $\overline{Y}_{cb}$, $\overline{X}_{cc}$, $\overline{Y}_{cc}$) für jede Aufnahmedüse (21) von einer vorbestimmten Anzahl von Korrekturwerten ($X_{cak}$, $Y_{cak}$, $X_{cbk}$, $Y_{cbk}$, $X_{cck}$, $Y_{cck}$) für jede Aufnahmedüse (21) separat berechnet wird, und daß der Korrekturmittelwert ($\overline{X}_c$, $\overline{Y}_c$) zur Änderung der Aufnahmepunkte (X, Y) von den Aufnahmedüsen (21) von den individuellen Korrekturmittelwerten ($\overline{X}_{ca}$, $\overline{Y}_{ca}$, $\overline{X}_{cb}$, $\overline{Y}_{cb}$, $\overline{X}_{cc}$, $\overline{Y}_{cc}$) für jede Aufnahmedüse (21) berechnet werden.

6. Verfahren nach zumindest einem der vorstehenden Ansprüche 2, 3 und 5, **dadurch gekennzeichnet**, daß das in dem Erfassungsbereich plazierte Bauelement mit parallelen Lichtstrahlen beaufschlagt und von dieser Aufnahmedüse (21) um eine im wesentlichen zu den Lichtstrahlen senkrechten Richtung rotiert wird, und daß während dieser Rotation die Projektionsweite ($W_s$) wiederholt erfaßt wird, um die Minimum-Projektionsweite ($W_{min}$) des Bauelementes sowie den zugehörigen Rotationswinkel ($\phi$) festzulegen, und um diesen Korrekturwert ($X_{cak}$, $Y_{cak}$, $X_{cbk}$, $Y_{cbk}$, $X_{cck}$, $Y_{cck}$) daraus zu erhalten.

7. Verfahren nach Anspruch 6, **dadurch gekennzeichnet,** daß das Bauelement mit Laserstrahlen beaufschlagt wird, die parallel in einer Ebene (X-Y) abgestrahlt werden, die im wesentlichen senkrecht zu der Achse ist, um welche das Bauelement rotiert wird.

8. Montiervorrichtung zum Montieren eines Bauelementes an einer spezifischen Position, insbesondere eines Chip-Bauelementes auf einem Substrat, wie z.B. eine gedruckte Leiterplatte (P), mit einer bewegbaren Montierkopfeinheit (5), die zumindest eine Aufnahmedüse (21) zum Aufnehmen von zumindest einem Bauelement von einer Zuführeinheit (4) für Bauelemente an einem vorbestimmten Aufnahmepunkt (X-Y) der Aufnahmedüse enthält, einer Positionserfassungseinrichtung (27) zur Erfassung einer Abweichung des aufgenommenen Bauelementes von einer vorbestimmten Position relativ zu der Aufnahmedüse (21), sowie mit Korrekturwert-Berechnungseinrichtungen (33) zur Berechnung von Korrekturwerten ($X_{cak}$, $Y_{cak}$, $X_{cbk}$, $Y_{cbk}$, $X_{cck}$, $Y_{cck}$) für eine Korrektur einer vorbestimmten Montierposition der Aufnahmedüse (21) für das Montieren des Bauelementes an dieser spezifischen Position in Abhängigkeit von dieser Abweichung, **dadurch gekennzeichnet,** daß eine Aufnahmepunkt-

9

Änderungseinrichtung (33, 34) vorhanden ist zur Änderung des vorbestimmten Aufnahmepunktes (X, Y) der Aufnahmedüse (21) in Abhängigkeit von diesen Korrekturwerten ($X_{cak}$, $Y_{cak}$, $X_{cbk}$, $Y_{cbk}$, $X_{cck}$, $Y_{cck}$).

9. Montagevorrichtung nach Anspruch 8, **dadurch gekennzeichnet,** daß die Aufnahmepunkt-Änderungseinrichtung eine Mittelwertberechnungseinrichtung (34) aufweist zur Berechnung eines Korrekturmittelwertes ($\bar{X}_c$, $\bar{Y}_c$) von einer vorbestimmten Anzahl von Korrekturwerten ($X_{cak}$, $Y_{cak}$, $X_{cbk}$, $Y_{cbk}$, $X_{cck}$, $Y_{cck}$), die von den Korrekturwert-Berechnungseinrichtungen (33) erhalten werden, wobei der Aufnahmepunkt (X, Y) der Aufnahmedüse (21) in Abhängigkeit von diesem Korrekturmittelwert ($\bar{X}_c$, $\bar{Y}_c$) geändert wird.

10. Montiervorrichtung nach Anspruch 8 oder 9, **dadurch gekennzeichnet,** daß die Montierkopfeinheit (5) eine Vielzahl von Aufnahmedüsen (21) zur Aufnahme einer Vielzahl von Bauelementen aufweist.

11. Montiervorrichtung nach Anspruch 10, **dadurch gekennzeichnet,** daß die Mittelwertberechnungseinrichtung (34) dazu ausgelegt ist, einen Korrekturmittelwert ($\bar{X}_{ca}$, $\bar{Y}_{ca}$, $\bar{X}_{cb}$, $\bar{Y}_{cb}$, $\bar{X}_{cc}$, $\bar{Y}_{cc}$) für jede Aufnahmedüse (21) von einer vorbestimmten Anzahl von Korrekturwerten ($X_{cak}$, $Y_{cak}$, $X_{cbk}$, $Y_{cbk}$, $X_{cck}$, $Y_{cck}$) für jede Aufnahmedüse (21) zu berechnen und des weiteren einen Korrekturmittelwert ($\bar{X}_c$, $\bar{Y}_c$) von den individuellen Korrekturmittelwerten ($\bar{X}_{ca}$, $\bar{Y}_{ca}$, $\bar{X}_{cb}$, $\bar{Y}_{cb}$, $\bar{X}_{cc}$, $\bar{Y}_{cc}$) für jede Aufnahmedüse (21) zur Änderung des Aufnahmepunktes (X, Y) zu berechnen.

12. Montiervorrichtung nach Anspruch 11, **dadurch gekennzeichnet,** daß die Mittelwertberechnungseinrichtung (34) drei Speichereinrichtungen aufweist zum Abspeichern der individuellen Korrekturmittelwerte ($\overline{X_{ca}}$, $\overline{Y_{ca}}$, $\overline{X_{cb}}$, $\overline{Y_{cb}}$, $\overline{X_{cc}}$, $\overline{Y_{cc}}$), die einer jeden Aufnahmedüse (21) zugeordnet sind.

13. Montiervorrichtung nach zumindest einem der Ansprüche 8 bis 12, **dadurch gekennzeichnet,** daß die Positionserfassungseinrichtung eine Lasereinheit (27) aufweist zur Erfassung einer Projektionsweite ($W_s$) des Bauelementes, das aufgenommen ist und rotiert wird, mit Hilfe von parallelen Lichtstrahlen, die von einem Lasererzeugungsabschnitt (27a) abgegeben werden, der an einer Seite der Montierkopfeinheit (5) angeordnet ist, und die von einem Erfassungsabschnitt (27b) empfangen werden, der an der entgegengesetzten Seite der Montiereinheit (5) angeordnet ist, wobei die Aufnahmedüse (21) zwischen diesem Erzeugungsabschnitt (27a) und diesem Erfassungsabschnitt (27b) angeordnet ist.

14. Montiervorrichtung nach Anspruch 11 und 13, **dadurch gekennzeichnet,** daß jede Aufnahmedüse (21) um ihre vertikale Achse (R-Achse) drehbar abgestützt sowie vertikal entlang einer Achse (Z-Achse) unabhängig voneinander vesetzbar ist und auch noch in einer Ebene (X-Achse, Y-Achse), die senkrecht zu dieser vertikalen Achse (Z-Achse) liegt, zusammen mit dieser Montierkopfeinheit (5) bewegbar ist, wobei diese Aufnahmedüse n (21) entlang einer Linie angeordnet sind, die bezüglich der Richtung der parallelen Lichtstrahlen der Positionserfassungseinrichtung (27) schräg verläuft, so daß an den Aufnahmedüsen (21) anhaftende Bauelemente in Richtung dieser parallelen Lichtstrahlen einander nicht überlappen.

15. Montiervorrichtung nach zumindest einem der Ansprüche 8 bis 14, **dadurch gekennzeichnet,** daß Servomotoren (22, 24) an der bzw. an jeder Aufnahmedüse (21) für deren Rotation bzw. deren Versatz angeschlossen sind, und zwar relativ zu der Montierkopfeinheit (5), daß Servomotoren (9, 15) vorgesehen sind zum Bewegen der Montierkopfeinheit (5) in der X-Achsen-Richtung und in der Y-Achsen-Richtung, daß Positonserfassungseinrichtungen (23, 25, 10, 16) einem jeden dieser Servomotoren (22, 24, 9, 15) zugeordnet sind, und daß diese Servomotoren (22, 24, 9, 15) und diese Erfassungseinrichtungen (23, 25, 10, 16) an einer Hauptsteuereinrichtung (30) elektrisch angeschlossen sind.

16. Montiervorrichtung nach den Ansprüchen 13 und 15, **dadurch gekennzeichnet,** daß die Hauptsteuereinrichtung (30) eine Aufnahmepunkt-Änderungseinrichtung aufweist, die diese Mittelwertsrechnungseinrichtung (34) aufweist, und elektrisch an die Lasereinheit (27) über eine Lasereinheit-Berechnungssektion (38) und eine Eingabeeinrichtung (32) angeschlossen ist.

17. Montiervorrichtung nach zumindest einem der Ansprüche 8 bis 15, **dadurch gekennzeichnet,** daß die bzw. jede Aufnahmedüse (21) mit einer Störposition-Erfassungseinrichtung (26) versehen ist zur Erfassung einer Position, in welcher sich die Bauelemente-Zuführeinheit (4) und die Aufnahmedüse (21) gegenseitig stören.

**Revendications**

1. Méthode de montage d'un composant sur une position spécifique, spécifiquement un composant en puce électronique sur un substrat tel qu'une plaquette à circuit imprimé (P), comprenant les étapes consistant à prélever le composant par l'intermédiaire d'une buse de prélèvement (21) depuis une unité de fourniture de composant (4), en une position de prélèvement prédéterminé de la buse de prélèvement, transférer le composant et le placer sur une zone de détection de moyens de détection optiques (27) en vue de détecter un écart entre la position du composant prélevé et une position de composant prédéterminée par rapport à la buse de prélèvement (21) et monter le composant à la position souhaitée, caractérisée par l'étape consistant à modifier la position de prélèvement prédéterminée de la buse de prélèvement (21) destinée au composant à prélever, subséquemment, en réponse à ladite détection d'un écart.

2. Méthode selon la revendication 1, caractérisée en ce qu'une valeur de correction ($X_{cak}$, $Y_{cak}$, $X_{cbk}$, $Y_{cbk}$, $X_{cck}$, $Y_{cck}$) pour corriger la position de montage prédéterminée de la buse de prélèvement (21), pour le montage du composant sur ladite position spécifique, est calculée en réponse audit écart.

3. Méthode selon la revendication 2, caractérisée en ce qu'une valeur de correction moyenne ($\overline{X}_c$, $\overline{Y}_c$) est calculée à partir d'un nombre prédéterminé de valeurs de correction (Xcak, Ycak, Xcbk, Ycbk, Xcck, Ycck) et la position de prélèvement prédéterminée de la buse de prélèvement (21) est modifiée en réponse à ladite valeur de correction moyenne ($\overline{X}_c$, $\overline{Y}_c$).

4. Méthode selon au moins l'une des revendications 1 à 3, caractérisée en ce qu'une pluralité de composants (K1,.... Kn) est prélevée par l'intermédiaire d'une pluralité de buses de prélèvement (21), simultanément ou successivement, tandis que d'autres étapes de détection dudit écart et d'obtention de valeurs de correction sont exécutées, au moins partiellement, en une procédure à partage de temps.

5. Méthode selon la revendication 4, caractérisé en ce qu'une valeur de correction moyenne ($\overline{X}_{ca}$, $\overline{Y}_{ca}$, $\overline{X}_{cb}$, $\overline{Y}_{cb}$, $\overline{X}_{cc}$, $\overline{Y}_{cc}$) est calculée pour chaque buse de prélèvement (21), séparément, à partir d'un nombre prédéterminé de valeurs de correction (Xcak, Ycak, Xcbk, Ycbk, Xcck, Ycck) pour chaque buse de prélèvement (21), et la valeur de correction moyenne ($\overline{X}_c$, $\overline{Y}_c$ destinée à modifier les points de prélèvement (X, Y) des buses de prélèvement (21) étant calculées à partir des valeurs de correction moyenne individuelle ($\overline{X}_{ca}$, $\overline{Y}_{ca}$, $\overline{X}_{cb}$, $\overline{Y}_{cb}$, $\overline{X}_{cc}$, $\overline{Y}_{cc}$) pour chaque buse de prélèvement (21).

6. Méthode selon au moins l'une des revendications 2, 3 et 5, caractérisée en ce que le composant placé dans la zone de détection est soumis à des faisceaux lumineux parallèles et tourné par ladite buse de rotation (21) autour d'un axe sensiblement perpendiculaire aux faisceaux lumineux, et pendant la rotation la largeur projetée ($W_s$) est répétitivement détectée de manière à déterminer la largeur de projection minimale ($W_{min}$) du composant et de l'angle de rotation ($\phi$) et pour obtenir ladite valeur ae correction ($X_{cak}$, $Y_{cak}$, $X_{cbk}$, $Y_{cbk}$, $X_{cck}$, $Y_{cck}$) à partir de cela.

7. Méthode selon la revendication 6, caractérisée en ce que le composant est soumis à des faisceaux laser émis parallèlement dans un plan (X-Y) sensiblement perpendiculairement à l'axe autour duquel le composant est tourné.

8. Dispositif de montage destiné à monter un composant sur une position spécifique, spécialement un composant en puce électronique sur un substrat tel qu'une plaquette à circuit imprimé (P), comprenant une unité à tête de montage mobile (5) supportant au moins une buse de prélèvement (21) destinée à prélèver au moins un composant depuis une unité d'alimentation en composants (4), en un point de prélèvement prédéterminé (X, Y) de la buse de prélèvement, des moyens de détection de position (27), conçus pour détecter un écart entre la position du composant prélevé et une position prédéterminée par rapport à la buse de prélèvement (21), et des moyens de calcul de valeur de correction (33) conçus pour calculer des valeurs de correction ($X_{cak}$, $Y_{cak}$, $X_{cbk}$, $Y_{cbk}$, $X_{cck}$, $Y_{cck}$) pour corriger une position de montage prédéterminée de la buse de prélèvement (21), en vue de monter le composant à ladite position spécifique, en réponse audit écart, caractérisé en ce que des moyens de changement de point de prélèvement (33, 34) sont prévus pour modifier le point de prélèvement prédéterminé (X, Y) de la buse de prélèvement (21) en réponse auxdites valeurs de correction ($X_{cak}$, $Y_{cak}$, $X_{cbk}$, $Y_{cbk}$, $X_{cck}$, $Y_{cck}$).

9. Dispositif de montage selon la revendication 8, caractérisé en ce que lesdits moyens de modification de point de prélèvement comprennent des moyens de calcul de moyenne (34) conçus pour calculer une valeur de correction moyenne ($\overline{X}_c$, $\overline{Y}_c$) à partir d'un nombre prédéterminé de valeurs de correction ($X_{cak}$, $Y_{cak}$, $X_{cbk}$, $Y_{cbk}$, $X_{cck}$, $Y_{cck}$) obtenues par les moyens de calcul de valeur de correction (33), les points de prélèvement (X, Y) de la buse de prélèvement (21) étant modifiés en réponse à ladite valeur de correction moyenne ($\bar{X}_c$, $\bar{Y}_c$).

10. Dispositif de montage selon la revendication 8 ou 9, caractérisé en ce que l'unité à tête de montage (5) comprend une pluralité de buses de prélèvement (21) destinée à prélever une pluralité de composants.

11. Dispositif de montage selon la revendication 10, caractérisé en ce que les moyens de calcul de moyenne (34) sont adaptés pour calculer une valeur de correction moyenne ($\bar{X}_{ca}$, $\bar{Y}_{ca}$, $\bar{X}_{cb}$, $\bar{X}_{cc}$, $\bar{Y}_{cc}$) pour chaque buse de prélèvement (21) à partir d'un nombre prédéterminé de valeurs de correction ($X_{cak}$, $Y_{cak}$, $X_{cbk}$, $Y_{cbk}$, $X_{cck}$, $Y_{cck}$) pour chaque buse de prélèvement (21) et en outre pour calculer une valeur de correction moyenne ($\bar{X}_c$, $\bar{Y}_c$) afin de modifier le point de prélèvement (X, Y) à partir des valeurs de correction moyennes individuelles ($\bar{X}_{ca}$, $\bar{Y}_{ca}$, $\bar{X}_{cb}$, $\bar{Y}_{cb}$, $\bar{X}_{cc}$, $\bar{Y}_{cc}$) de chaque buse de prélèvement (21).

12. Dispositif de montage selon la revendication 11, caractérisé en ce que les moyens de calcul de moyenne (34) comprennent trois moyens à mémoire destinés à stocker les valeurs de correction moyennes individuelles ($\bar{X}_{ca}$, $\bar{Y}_{ca}$, $\bar{X}_{cb}$, $\bar{Y}_{cb}$, $\bar{X}_{cc}$, $\bar{Y}_{cc}$) associées à chaque buse de prélèvement (21).

13. Dispositif de montage selon au moins l'une des revendications 8 à 12, caractérisé en ce que les moyens de détection de position comprennent une unité laser (27) destinée à détecter une largeur projetée (Ws) du composant prélevé et tourné, au moyen de faisceaux lumineux parallèles émis depuis une section de génération laser (27a) disposée d'un côté de l'unité à tête de montage (5) et reçus par une section de détection (27b) disposée sur le côté opposé de l'unité de montage (5), la buse de prélèvement (21) étant disposée entre ladite section de génération (27a) et ladite section de détection (27b).

14. Dispositif de montage selon les revendications 11 et 13, caractérisé en ce chaque buse de prélèvement (21) est supportée à rotation autour de son axe vertical (axe R) et est déplaçable verticalement suivant un axe (axe Z) indépendamment l'un de l'autre et déplaçable dans un plan (axe X, axe Y) perpendiculaire audit axe vertical (axe Z), conjointement avec ladite unité à tête de montage (5), lesdites buses de prélèvement (21) étant agencées sur une ligne oblique par rapport à la direction des faisceaux lumineux parallèles des moyens de détection de position (27), de manière que les composants attirés sur les buses de prélèvement (21) ne se chevauchent pas dans la direction desdits faisceaux lumineux parallèles.

15. Dispositif de montage selon au moins l'une des revendications 8 à 14, caractérisé en ce que des servo-moteurs (22, 24) sont connectés à chaque buse de prélèvement (21) pour faire tourner et déplacer celle-ci, respectivement, par rapport à l'unité à tête de montage (5), des servo-moteurs (9, 15) sont prévus pour déplacer l'unité à tête de montage (5) dans la direction de l'axe X et dans la direction de l'axe Y, des moyens de détection de position (23, 25, 10, 16) étant associés à chacun desdits servo-moteurs (22, 24, 9, 15), et en ce que lesdits servo-moteurs (22, 24, 9, 15) et lesdits moyens de détection (23, 25, 10, 16) sont connectés électriquement à un contrôleur principal (30).

16. Dispositif de montage selon les revendications 13 et 15, caractérisé en ce que ledit contrôleur principal (30) comprend les moyens de changement de point de prélèvement, y compris les moyens de calcul de moyenne (34), et est connecté électriquement à l'unité laser (27), via une section de calcul d'unité laser (38) et des moyens d'entrée (32).

17. Dispositif de montage selon au moins l'une des revendications 8 à 15, caractérisé en ce que chaque buse de prélèvement (21) est pourvue de moyens de détection de position d'interférence (26), afin de détecter une position d'interférence de l'unité de fourniture de composant (4) et de la buse de prélèvement (21) .

Fig. 1

Fig. 2

Fig. 3

Fig. 4

Fig. 5

Fig. 6

```
                    ┌───────────┐
                    │  S T A R T │
                    └─────┬─────┘
                          │◄──────────────────────┐
  S20                     ▼                        │
         ╱────────────────────────────────╲        │
        ╱  PICKUP NOZZLE RAISED TO          ╲  NO  │
        ╲  RECOGNITION HEIGHT;              ╱──────┘
         ╲ PRELIMINARY ROTATION           ╱
          ╲ COMPLETE?                    ╱
            ╲──────────┬─────────────╱
                       │ YES
  S21                  ▼
        ┌─────────────────────────────┐
        │   DETECTING Cs, Ws, θs       │
        └──────────────┬──────────────┘
  S22                  ▼
        ┌─────────────────────────────┐
        │  PICKUP NOZZLE ROTATION;     │
        │  MINIMUM COMPONENT PRO-      │
        │  JECTED WIDTH DETECTION      │
        └──────────────┬──────────────┘
                       │◄──────────────────────┐
  S23                  ▼                        │
         ╱────────────────────────────╲  NO    │
        ╱  PICKUP NOZZLE ROTATION       ╲───────┘
        ╲  BY θe?                       ╱
         ╲────────────┬──────────────╱
                      │ YES
  S24                 ▼
        ┌─────────────────────────────┐
        │   DETECTING Cm, Wmin, θm     │
        └──────────────┬──────────────┘
  S25                  ▼
         ╱────────────────────────╲   NO
        ╱  COMPONENT IS PICKED      ╲────────────┐
        ╲  UP NORMALLY?             ╱            │
         ╲──────────┬─────────────╱              │
  S27                │ YES               S26     ▼
        ┌─────────────────────────┐      ┌───────────────┐
        │ CALCULATING CORRECTION   │      │  COMPONENT    │
        │ AMOUNTS Xc, Yc, θc;      │      │  REMOVAL      │
        │ STORING Xcan ← Xc,       │      └───────────────┘
        │ Ycan ← Yc                │
        └────────────┬─────────────┘
  S28                ▼                  S30
          ┌───────────────┐         ┌──────────────────────┐
          │  n = n + 1     │         │  CALCULATE AVERAGE    │
          └───────┬────────┘         │  FOR EACH NOZZLE      │
  S29             ▼                  │  X̄ca,  Ȳca           │
         ╱──────────────╲  YES       │  X̄cb,  Ȳcb           │
        ╱    n = K       ╲──────────►│  X̄cc,  Ȳcc           │
        ╲                ╱           └──────────┬───────────┘
         ╲──────┬───────╱            S31         ▼
                │ NO                 ┌──────────────────────┐
                │                    │  CALCULATE AVERAGE    │
                │                    │  CORRECTION AMOUNTS   │
                │                    │     X̄c,  Ȳc          │
                │                    └──────────┬───────────┘
                │                    S32         ▼
                │                    ┌──────────────────────┐
                │                    │  CHANGE PICKUP POINT  │
                │                    │ (Xpm+ X̄c, Ypm+ Ȳc)   │
                │                    └──────────┬───────────┘
                │                               ▼
                │                         ┌───────────┐
                └────────────────────────►│  E N D    │
                                          └───────────┘
```

18